# DEMANDE DE BREVET EUROPEEN

(11) **EP 4 766 083 A1**
(43) Date de publication de la demande: **24.06.2026**
(21) Numéro de dépôt: 25222322.7
(22) Date de dépôt: 10.12.2025
(51) Int. Cl.: H10D 48/01, H10D 48/00, H10D 64/27, B82Y 10/00

(54) **FABRICATION D'UN RÉSEAU DE POINTS QUANTIQUES ET PROCÉDÉS PERMETTANT D'ASSURER UNE CONNEXION EFFICACE ENTRE GRILLES DIFFÉRENTES**

(30) Priorité: 18.12.2024 FR 2414493
(71) Demandeur: Commissariat à l'Energie Atomique et aux Energies Alternatives, 75015 Paris (FR)
(72) Inventeur: BERTRAND, Benoit, 38054 GRENOBLE CEDEX 09 (FR)
(74) Mandataire: Atout PI Laplace

(57) **Abrégé**

Dispositif électronique quantique comprenant :
- une zone active (20) pour accueillir des boites quantiques et,
- affleurants sur une face du dispositif :
a) une pluralité de lignes de grille (G11, G12, G13, G14), isolées électriquement les unes des autres et recouvrant chacune une partie de la zone active (20), et
b) des ilots de facilitation de reprise de contact (14-17, I4a-I7a) à raison d'au moins un ilot pour une ligne de grille, les ilots de facilitation de reprise de contact étant éloignés les uns des autres d'une distance (D1, D2, D3), chaque ilot de facilitation de reprise de contact comprenant un flanc le long duquel une partie latérale (P4-P7) d'une ligne de grille s'étend,

le dispositif comprenant de plus
au moins un contact électrique (P4-P7) pour contacter au moins une ligne de grille donnée (G11, G12, G13, G14), l'au moins un contact électrique étant situé au moins sur la partie latérale de la ligne de grille donnée qui s'étend le long du flanc d'un ilot de facilitation de reprise de contact (14-17, I4a-I7a).

## Description

### Contexte technique

Le domaine de l'invention est l'informatique quantique et plus spécifiquement le stockage de l'information quantique. Dans l'approche considérée, les qubits ou bits quantiques sont réalisés dans des boîtes quantiques qui assurent le confinement de charges élémentaires qui sont des électrons ou des trous au sein de structures en matériaux semiconducteurs tels le silicium. Ces boîtes quantiques sont couplées entre elles par l'intermédiaire de barrières à effet tunnel. L'information quantique est, par exemple, codée sur le spin des électrons ou le spin des trous. L'approche fondée sur le silicium tire parti des technologies CMOS (Complementary Metal Oxide Semiconductor) et permet un fonctionnement à des températures accessibles de l'ordre de 1 K.

Pour définir et contrôler correctement un réseau de boîtes quantiques, il est nécessaire de disposer d'électrodes dites grilles (ou gates en anglais) permettant un ajustement local du potentiel électrostatique.

Typiquement, des grilles sont dédiées au contrôle du potentiel des boîtes quantiques. Et d'autres grilles servent au contrôle des barrières à effet tunnel entre les boîtes.

En pratique, des défauts chargés sont présents dans les matériaux (par exemple le long d'une interface Si-SiO₂ entre une couche de silicium et une couche de dioxyde de silicium), et perturbent localement le potentiel, créant un désordre électrostatique qui se superpose au potentiel généré par les tensions de grilles. On cherche naturellement à optimiser les matériaux et les interfaces pour réduire les densités de défauts présents, mais cela n'est pas facile, et des défauts sont toujours présents.

Quand l'amplitude du désordre de potentiel causé par les défauts chargés est importante, on peut utiliser un pas de grille qui approche ou est inférieur à la longueur caractéristique du désordre pour améliorer la définition des boîtes quantiques et barrières à effet tunnel.

Une réponse à cette problématique consiste donc à réaliser des arrangements de grilles les plus denses possible. Par exemple, un constructeur a réduit le pas des grilles à 50 nm via une intégration de grilles autoalignées dite *nested gates* (US10741664, Zverwer et al., Nat. Elec. 2022, 5, 184) ou via l'utilisation de lithographie extrême ultra-violet EUV (Neyens et al., Nature 2024, 629, 80).

Sur les technologies dites SiMOS (MOS : Metal Oxide Semiconductor ou semiconducteur métal oxyde), où les boîtes quantiques sont formées à une interface Si/SiO2, ces valeurs de pas restent aujourd'hui parfois insuffisantes pour garantir un excellent contrôle des structures quantiques formées. Il serait donc intéressant de pouvoir réaliser des structures de bits quantiques SiMOS encore plus denses.

Un problème additionnel survient au niveau de la reprise de contact lorsque les dimensions et le pas de grille sont faibles : pour éviter qu'un contact ne connecte plusieurs grilles à la fois, il doit être d'une taille inférieure au pas de grille et être parfaitement aligné.

Pour relâcher ces contraintes, une solution consiste à épanouir les grilles à distance du composant électronique vers des régions de taille disponible plus importante pour y réaliser la reprise de contact. La géométrie de grilles épanouies implique la réalisation de lignes selon différentes orientations, plus complexe que des lignes toutes parallèles. On a proposé dans US10741664 des géométries en L avec des côtés de L parallèles les uns aux autres mais de taille décroissante depuis le centre d'un côté du composant vers l'extérieur de celui-ci, la reprise de contact restant néanmoins délicate, d'où des risques de pontage. On a aussi proposé dans Zverwer et al. (mentionné plus haut) des géométries en secteurs angulaires utilisant proportionnellement plus de surface autour du composant.

Lorsque les grilles approchent des dimensions en limite de résolution lithographique, la réalisation de tels motifs peut cependant s'avérer complexe.

Pour des structures avec des pas de grilles extrêmement réduits, il est donc intéressant de chercher à faciliter la reprise de contact, par tout moyen qui serait facile à industrialiser.

Un substrat particulièrement avantageux est le substrat SOI (silicium sur isolant). Il est présenté sous forme de galettes (wafer) circulaires.

### Caractéristiques de l'invention et avantages

On souhaite donc obtenir un pas de grilles très fin pour un contrôle fin du potentiel et compensation du désordre électrostatique, tout en facilitant la reprise de contact pour des pas de grilles inférieurs aux dimensions des contacts.

Pour cela il est proposé un dispositif électronique quantique comprenant :
- une zone active pour accueillir des boites quantiques et,
- affleurants sur une face du dispositif :

a) une pluralité de lignes de grille, isolées électriquement les unes des autres et recouvrant chacune une partie de la zone active,
b) des ilots de facilitation de reprise de contact à raison d'au moins un ilot pour une ligne de grille, les ilots de facilitation de reprise de contact étant éloignés les uns des autres d'une distance, chaque ilot de facilitation de reprise de contact comprenant un flanc le long duquel une partie latérale d'une ligne de grille s'étend,
le dispositif comprenant de plus au moins un contact électrique pour contacter au moins une ligne de grille donnée, l'au moins un contact électrique étant situé au moins sur la partie latérale de la ligne de grille donnée qui s'étend le long du flanc d'un ilot de facilitation de reprise de contact.

On choisit des surfaces isolées - les ilots - de dimensions, dans le plan, supérieures à la largeur des lignes de grille. Celles-ci conduisent le courant de leur partie qui recouvre la zone active jusqu'à une reprise de contact qui est facilitée lors de la fabrication par la présence des ilots de facilitation de reprise de contact.

Cette stratégie permet la réalisation d'un réseau de boîtes quantiques à pas réduit, puisque, malgré le pas réduit, les reprises de contact sont facilitées par la tolérance qui est offerte au vu d'une zone isolée - l'ilot- vers laquelle la tolérance est appliquée lors de la mise en place de la reprise de contact. Les ilots peuvent alterner avec les parties qui s'étendent le long du flanc - celle-ci formant branches, chaque branche pouvant bénéficier d'une zone de contact avec tolérance qui lui est dédiée.

Pour cela on propose un arrangement de boîtes quantiques avec grilles de contrôle définies par plusieurs espaceurs, les largeurs des espaceurs étant définies par la résolution des épaisseurs de dépôt, ce qui permet in fine des dimensions très faibles pour le pas de grille mis en place.

Plusieurs propositions de design sont associées à ces principes, et permettent toutes de faciliter la reprise de contact.

Selon des caractéristiques optionnelles et avantageuses :
- les ilots de facilitation de reprise de contact peuvent être entourés d'une alternance d'espaceurs diélectriques et d'espaceurs conducteurs en nombres qui vont croissants avec la distance vis-à-vis de la zone active.
- l'écartement entre deux ilots de facilitation de reprise de contact voisins peut augmenter avec la distance vis-à-vis de la zone active.
- les contacts électriques peuvent tous être placés entre deux ilots de facilitation de reprise de contact voisins mais en s'approchant plus de l'ilot voisin (ou les deux ilots voisins) ou débordant plus sur l'ilot voisin (ou les deux ilots voisins) pour les contacts plus proches de la zone active que pour les contacts plus éloignés de la zone active.
   le dispositif peut comprendre un substrat en silicium massif ou en silicium sur isolant.
- la zone active peut comprendre un nanofil.
- la zone active peut présenter deux extrémités, au moins une des extrémités formant un réservoir de porteurs de charges.
- les ilots de facilitation de reprise de contact peuvent avoir une surface en matériau électriquement isolant, ou en matériau électriquement conducteur.
- les grilles permettent l'ajustement local du potentiel électrostatique dans la zone active.
- un contact électrique peut être placé à cheval sur un ilot de facilitation de reprise de contact, au moins un espaceur diélectrique et une partie latérale formant branche, ou à cheval sur une partie latérale formant branche et un espaceur diélectrique sans avoir de contact avec un ilot de facilitation de reprise de contact, ou à cheval sur une partie latérale formant branche, deux îlots de facilitation de reprise de contact voisins et au moins deux espaceurs diélectriques.
- un contact électrique peut joindre une branche latérale entre deux ilots de facilitation de reprise de contact disposés l'un par rapport à l'autre dans une direction essentiellement parallèle à une direction d'allongement de la zone active.
- un contact électrique peut joindre une partie latérale formant branche entre deux ilots de facilitation de reprise de contact disposés l'un par rapport à l'autre dans une direction transversale à une direction d'allongement de la zone active.
- les boîtes quantiques peuvent être des boites quantiques pour qubit.

L'arrangement s'étend selon une dimension, avec possibilité d'intégrer un second réseau de boîtes quantiques en vis-à-vis pour permettre la lecture de qubits.

L'invention peut notamment être mise en œuvre avec le procédé de fabrication suivant :
un procédé de fabrication d'un dispositif électronique quantique, par exemple de stockage d'information quantique, comprenant une mise en place, sur un substrat, d'une zone active, et d'une pluralité de lignes de grille, isolées électriquement les unes des autres, et entre les lignes de grille et la zone active, d'une couche de matériau diélectrique, le procédé comprenant des étapes de formation de tranchées par gravure dans un matériau conducteur posé sur le substrat, puis dépôts conformes successifs d'espaceurs diélectriques et d'espaceurs conducteurs, des largeurs de tranchées allant croissantes en s'éloignant de la zone active, les espaceurs conducteurs, le procédé comprenant de plus la mise en place d'au moins un contact électrique pour contacter au moins une ligne de grille donnée, l'au moins un contact électrique étant situé au moins sur une partie latérale de la ligne de grille donnée s'étendant le long d'un flanc d'un ilot de facilitation de reprise de contact.

Ce procédé de fabrication est particulièrement efficace pour former les lignes de grille et les surfaces isolées.

Et selon des caractéristiques à nouveau optionnelles et avantageuses,
chaque dépôt conforme peut être suivi d'une gravure anisotrope avant le dépôt suivant
ou alternativement les dépôts d'espaceurs diélectriques et d'espaceurs conducteurs peuvent être effectués avant des gravures anisotropes du matériau conducteur puis du matériau diélectrique.
les tranchées peuvent comprendre des tranchées en maillage, une tranchée transversale au conducteur allongé s'élargissant en s'éloignant du conducteur allongé à chaque croisement d'une tranchée parallèle au conducteur allongé.

Le design proposé permet de tolérer un désalignement des contacts par rapport aux motifs précédemment réalisés sur le substrat sans risque de mettre en court-circuit les différentes grilles du dispositif.

Une mise à l'échelle de ce type de structure est possible par interconnexion de différents nœuds, par exemple via des résonateurs supraconducteurs.

### Liste des figures

Les figures 1 à 13 sont relatives à un premier mode de réalisation.
La figure 1 montre une première étape de procédé relative à la préparation d'un substrat de départ.
La figure 2 montre une deuxième étape de procédé, relative à une gravure d'un fil.
La figure 3 montre une troisième étape de procédé, relative à un dépôt des éléments de base pour former la grille.
La figure 4 montre une quatrième étape de procédé, relative à une gravure effectuée sur ces éléments.
La figure 5 montre une cinquième étape de procédé, relative à un dépôt/gravure d'un 1er espaceur diélectrique.
La figure 6 montre une sixième étape de procédé, relative à un dépôt/gravure d'un 1er espaceur conducteur.
Les figures 6B et 6C montrent deux variantes du procédé.
La figure 7 montre une septième étape de procédé, relative à un dépôt/gravure d'un 2ème espaceur diélectrique suivi d'un dépôt/gravure d'un 2ème espaceur conducteur.
La figure 8 montre une huitième étape de procédé, relative à un dépôt/gravure d'un 3ème espaceur diélectrique suivi d'un dépôt/gravure d'un 3ème espaceur conducteur.
La figure 9 montre une neuvième étape de procédé, relative à un dépôt/gravure d'un Nème espaceur diélectrique suivi d'un dépôt/gravure d'un 3ème espaceur conducteur.
La figure 10 montre une dixième étape de procédé, relative à un polissage mécano-chimique CMP, optionnel.
La figure 11 montre une onzième étape de procédé, relative à la mise en place d'un masque de lithographie et la gravure subséquente sur le matériau de grille, pour former les grilles.
La figure 12 montre le résultat de la gravure.
La figure 13 montre une douzième étape de procédé, relative à la reprise de contact.
La figure 14 explicite la reprise de contact.
La figure 15 montre une première variante incluant dépôts successifs d'espaceurs, dé-court-circuitage et mise en place de contacts individuels.
La figure 16 montre une deuxième variante incluant de mêmes étapes.

### Description en relation avec les figures

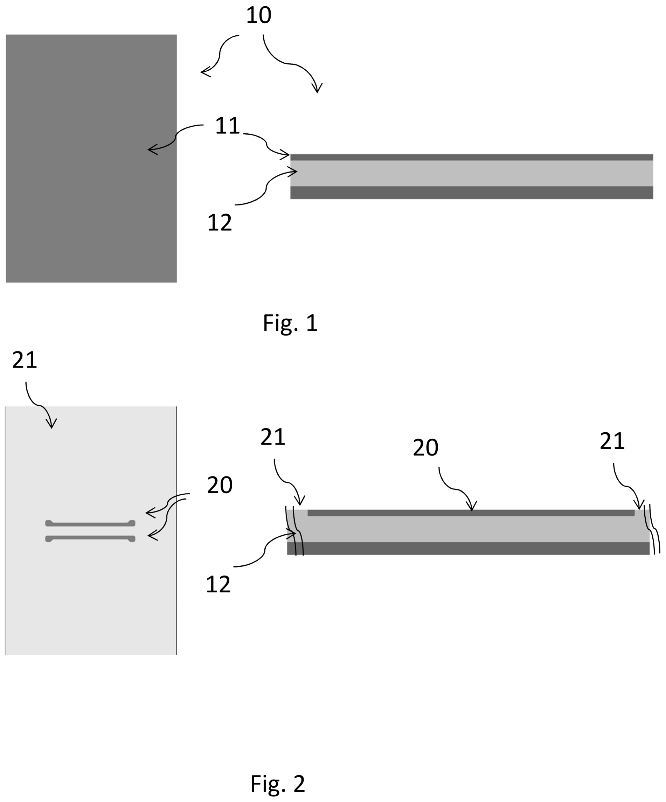

Les figures 1 à 13 sont relatives à un premier mode de réalisation de la fabrication d'un dispositif électronique quantique et un mode de réalisation correspondant du dispositif électronique quantique lui-même. A gauche, sur chaque figure, une vue du dessus est représentée, tandis qu'à droite, on a représenté une vue de côté, en coupe.

[Fig. 1] En figure 1, on a représenté une portion du substrat de départ 10. Cette portion de substrat, représentée ici rectangulaire (le substrat s'étend arbitrairement loin dans le plan, sa limite physique étant le bord de la plaque - dans les faits, il est donc généralement circulaire), possède une surface plane de travail 11, à savoir une surface cristalline de silicium, de profondeur par exemple environ 20 nm.

Le substrat de départ 10 a par exemple été produit en se procurant du silicium sur isolant SOI, qui possède une fine couche de silicium, d'environ 10 nm (généralement 12 à 16 nm) d'épaisseur sur une sous-couche isolante 12 de dioxyde de silicium SiO₂, et (optionnellement) en ayant réalisé sur la surface plane en silicium de ce substrat de départ une épitaxie, en sorte de faire croitre jusqu'à la hauteur souhaitée qui peut être de 20 nm - plage de valeurs avantageuses : 5-30nm - une couche de silicium. Celle-ci va permettre de former l'élément de conduction électrique dont on a besoin à la surface du substrat, sur un support de préférence isolant - le SiO₂ du substrat.

Dans des variantes le SOI est remplacé par du silicium massif (bulk silicon, non représenté) posé ou non sur une couche d'isolant (par exemple dioxyde de silicium SiO₂).

[Fig. 2] En figure 2, on a représenté le résultat d'une étape de gravure, dans la couche supérieure de silicium préparée à l'étape précédente, de nanofils 20 (nanowire) au nombre de deux, parallèles l'un à l'autre et s'interrompant au droit l'un de l'autre à chacune de leurs deux extrémités, dans le mode de réalisation représenté.

Les nanofils 20 s'étendent par exemple parallèlement à un côté du rectangle formant le substrat, mais sans atteindre les bords d'un côté ou de l'autre.

Au moins un nanofil 20 est nécessaire pour la mise en œuvre de l'invention. Le nanofil constitue une zone active pour l'accueil de boites quantiques, cette zone active présentant deux extrémités, dont une au moins forme un réservoir de porteurs de charges. La présence des deux nanofils 20 est avantageuse, parce qu'elle permet de préparer simultanément deux réseaux de boîtes quantiques indépendants l'un de l'autre, mais sur le même substrat, et avec les mêmes étapes de procédé. Les deux nanofils 20 sont par exemple placés parallèlement aux petits côtés du rectangle, de part et d'autre de la médiatrice des grands côtés, pour qu'autant d'espace soit disponible d'un côté de l'un que du côté opposé de l'autre.

Pour ainsi délimiter ces nanofils, un masque (non représenté) a été placé à la surface pour protéger la matière devant former les nanofils, et une gravure a été effectuée pour supprimer le silicium autour de la matière protégée. La gravure est interrompue à la hauteur de la sous-couche isolante 12 sous-jacente, de telle sorte que chacun des deux nanofils 20 est isolé électriquement de l'autre. Le masque est supprimé une fois la gravure effectuée. Ainsi, sur l'essentiel de la surface du substrat, l'isolant est à découvert, sauf dans la région définissant chacun des nanofils, où le silicium subsiste.

Différents types de gravure, notamment sèches, peuvent être utilisés.

Optionnellement mais avantageusement, on comble ensuite l'espace dégagé autour des nanofils de silicium avec de l'isolant 21 (par exemple du dioxyde de silicium) dans un processus de remplissage suivi d'une planarisation oxyde. On utilise optionnellement un procédé de type STI (Shallow trench isolation) ou isolation par tranchées peu profondes, auquel cas, sur SOI, la gravure des nanofils peut être poursuivie jusqu'à retirer l'oxyde enterré et une partie du silicium massif. La surface est alors essentiellement plane, les nanofils affleurant à la surface mais ayant leurs flancs entourés d'isolant 21 ajouté lors de cette étape de remplissage.

A la place d'un nanofil, on peut graver une ailette (fin en anglais).

Le rôle de cette structure, fine selon sa direction transverse parallèle au plan du substrat, est de confiner les charges dans une dimension.

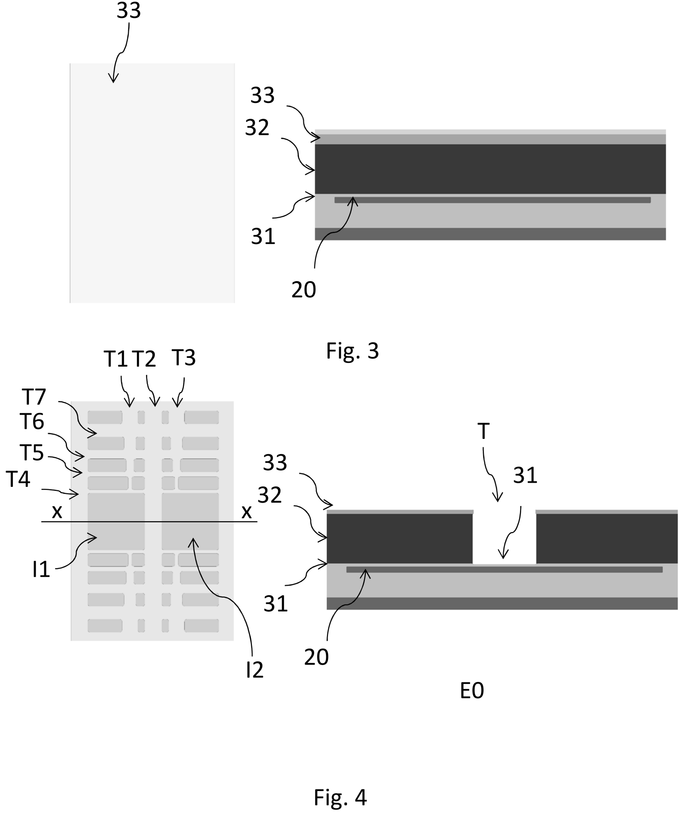

[Fig. 3] En figure 3, on a représenté le résultat d'une étape de dépôt, sur la surface portant les nanofils - aplanie par remplissage, ou non- d'un empilement 30 pour formation de grille.

Cet empilement apporté comprend, en partant de la partie du substrat où affleurent les nanofils, une couche de diélectrique (un ou plusieurs matériaux différents - dioxyde de silicium, dioxyde d'hafnium, ou trioxyde d'aluminium, par exemple, ou encore un empilement de ces matériaux) sur 5 à 15 nm environ, pour former ce qui est appelé par la suite le diélectrique de grille 31.

Puis l'empilement comprend une couche de matériau conducteur électrique 32, polysilicium ou métal conducteur, sur une hauteur plus importante, de 100 nm environ ou plus (en fonction du nombre final de grilles prévu), suivie d'un masque dur 33 (de nitrure de silicium SiN, ou de dioxyde de silicium SiO₂ notamment). C'est ce masque dur 33 qui est maintenant à la surface de la structure.

Dans une variante l'empilement initial ne comporte pas de matériau conducteur. Son premier rôle est de servir de support à la réalisation des espaceurs dans la suite du mode de réalisation. Pour cela, un matériau diélectrique conviendrait aussi.

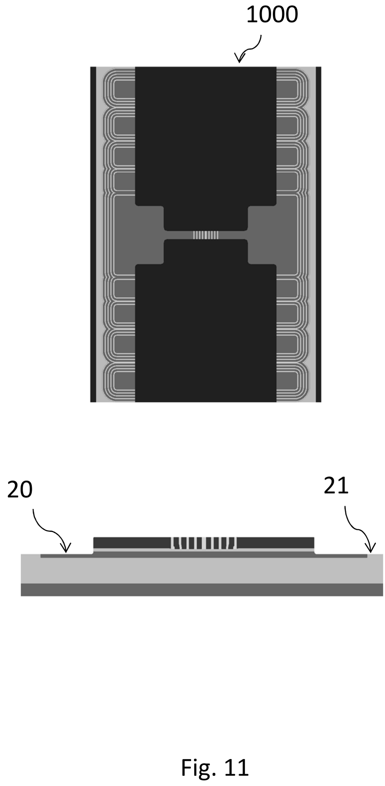

Le second rôle de l'empilement quand il comprend un matériau conducteur est de former des grilles d'accès access gates pour la source et le drain. Il serait possible de s'en passer, en adaptant le motif gravé à la figure 11 pour étendre la source et le drain jusqu'aux premiers espaceurs 61-62.

Utiliser un matériau conducteur est donc avantageux car il permet la formation de grilles supplémentaires dans la structure, mais ce n'est pas une obligation.

[Fig. 4] En figure 4, on a représenté le résultat d'une étape de gravure E0 (précédée d'une lithographie pour définir un masque), par exemple une gravure sèche, de l'empilement des matériaux précédent, avec arrêt de la gravure à la hauteur du diélectrique de grille 31. Ainsi, la partie extérieure dure, qui sert à masquer les parties protégées et à l'inverse a été retirée avant la gravure sur les parties à graver, et la couche épaisse de conducteur ont disparu sur les zones gravées.

Le substrat a fait l'objet, aux fins de cette étape de gravure, d'un masquage définissant un réseau de tranchées de différentes largeurs, parallèles aux grands côtés du rectangle pour certaines, et aux petits côtés du rectangle pour d'autres. Le dessin est symétrique par rapport au plan x-x de symétrie des deux nanofils 20.

Ces tranchées sont pour un nanofil (il y en a deux sur la figure 4, au nombre de
- trois parallèles aux grands côtés du rectangle, notée T1, T2, T3, dont une, placée en position centrale, T2, traverse le substrat d'un bord au bord opposé,
- et quatre parallèles aux petits côtés, notées T4, T5, T6 et T7 traversant toutes le rectangle d'un bord au bord opposé.
- On décrit ici le cas particulier d'un dispositif comportant 2x4 grilles par nanofil, ce qui est le cas représenté sur les figures. Mais ce nombre de grilles peut être variable (de 2x1 à 2xN grilles, N pouvant s'élever jusqu'à une dizaine voire quelques dizaines. Les tranchées définissent des ilots, qui vont servir à faciliter la reprise de contact. Il y a par exemple au-delà de la tranchée T4 en s'éloignant du nanofil, 4 ilots entre les tranchées T1 et T2, ces quatre ilots formant un alignement de 4 ilots placés à des distances croissantes vis-à-vis du nanofil. Il y a autant d'ilots de l'autre côté de la tranchée T2. Et il y a aussi des ilots en vis-à-vis de ces ilots par rapport aux tranchées T1 et T3, soit un total de 16 ilots pour faciliter 8 reprises de contact différentes.

On peut également avoir un nombre de grilles impair, dans le cas où le dernier espace de la tranchée T2 est comblé par une couche de matériau conducteur. Elles définissent ainsi deux iles centrales I1 et I2 au-dessus du nanofil (et commun aux deux nanofils), et 16 îlots latéraux de chaque côté du plan x-x.

Les deux tranchées perpendiculaires au nanofil et latérales T1 et T3 s'élargissent en s'éloignant du nanofil vers le petit côté du substrat qui lui est parallèle. Leur élargissement n'est pas continu mais est par pas, puisqu'elles s'élargissent à chaque fois qu'elles croisent une tranchée perpendiculaire, tout en restant de largeur constante entre deux croisements.

La tranchée centrale T2 parallèle aux grands côtés du substrat est quant à elle de largeur constante.

Les quatre tranchées parallèles aux petits côtés du rectangle, T4 à T7, sont chacune de largeur constante, mais de l'une à l'autre, la largeur augmente au fur et à mesure que l'on s'éloigne du nanofil. Ainsi T4 est plus étroite que T5, elle-même plus étroite que T6 elle-même plus étroite que T7.

Un cadre rectangulaire est également gravé sur le bord du substrat (il est visible sur la partie gauche de la figure, mais n'est pas représenté sur la partie droite). Il participe à délimiter latéralement les iles et îlots.

Un re-dépôt de diélectrique de grille 31 est mis en œuvre dans certaines variantes au fond des tranchées, par exemple la tranchée T qui peut être n'importe laquelle des tranchées (même si sur le dessin, il s'agit de la tranchée T2), par exemple par dépôt de couches atomiques (Atomic layer deposition ALD).

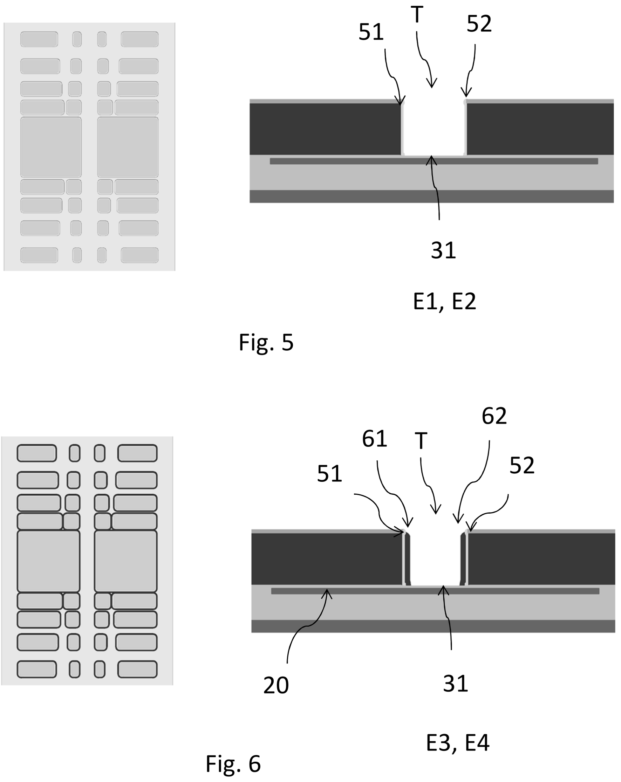

[Fig. 5] En figure 5, on a représenté le résultat d'une étape de dépôt E1 (non représenté, mais assimilable à un dépôt conforme, par exemple par dépôt de couches atomiques ALD) puis gravure anisotrope E2 d'un 1^{er} couple d'espaceurs en matériau diélectrique, par exemple le dioxyde de silicium SiO₂. Ce matériau forme, à l'issue de ces deux sous-étapes, une couche d'épaisseur de 5 à 10 nm, uniquement sur les parties verticales de la structure, à savoir les flancs de la couche épaisse de matériau conducteur dans chacune des tranchées T. Il occupe, dans chaque tranchée, une première partie à une extrémité de la tranchée, constituant un espaceur isolant 51, et une autre première partie de la tranchée à l'extrémité opposée, constituant un deuxième espaceur isolant 52. Les espaceurs isolants 51 et 52 forment une continuité isolante avec le diélectrique de grille 31. Si l'empilement initial ne comporte pas de matériau conducteur, comme cela a été envisagé à titre de variante, les étapes E1 et E2 de la figure 5 sont inutiles et on peut passer directement aux étapes suivantes de dépôt d'espaceurs conducteurs. Néanmoins plusieurs cycles sont menés en tout état de cause comme cela est présenté ci-après, et les cycles suivants comportent quant à eux les étapes E1 et E2 de dépôt d'espaceurs isolants. Ceux-ci alternent avec des espaceurs conducteurs.

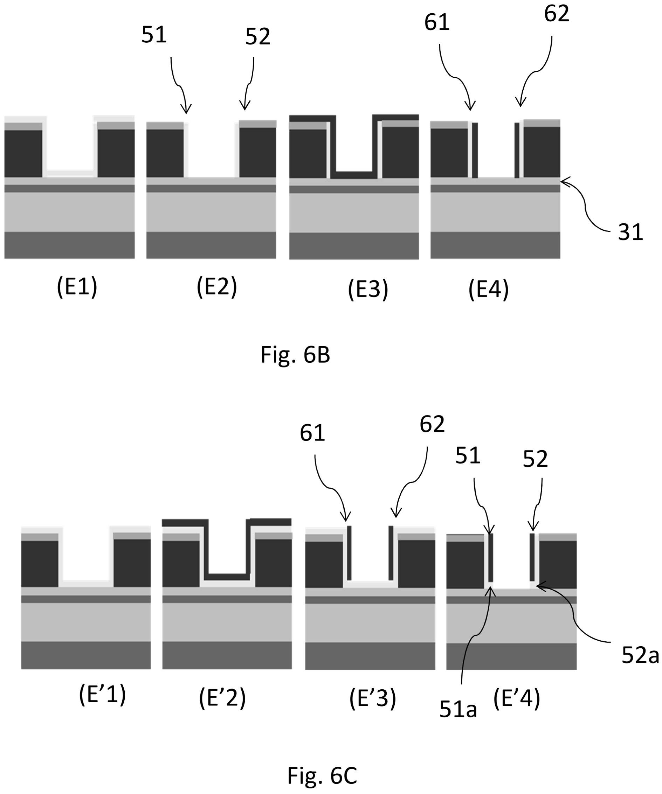

[Fig. 6] En figure 6, on a représenté le résultat d'une étape de dépôt E3 (non représenté, mais assimilable à un dépôt conforme, par exemple par dépôt de couches atomiques ALD) puis gravure anisotrope E4 d'une 1^{ere} paire de conducteurs (ou d'espaceurs conducteurs). Ils ont chacun une épaisseur de 5 à 15 nm, uniquement sur les parties verticales de la structure, à savoir les flancs de la couche épaisse de matériau conducteur dans chacune des tranchées T, d'ores et déjà recouverts d'espaceurs isolants. Ils occupent une deuxième partie à la première extrémité de la tranchée, recouvrant le diélectrique (recouvrant l'espaceur isolant 51), et une autre deuxième partie de la tranchée à l'extrémité opposée, recouvrant aussi le diélectrique (recouvrant l'espaceur isolant 52). Les espaceurs conducteurs 61 et 62 sont isolés du nanofil 20 par le diélectrique de grille 31. Chacun des espaceurs conducteurs 61 et 62 forment la matière de laquelle est constituée une ligne de grille, qui assure le rôle de grille vis-à-vis de la zone active - dans l'exemple présenté, un nanofil, et qui s'étend le long d'une tranchée, sous forme donc d'une ligne.

Ainsi, on a décrit un enchainement d'étapes.

[Fig. 6B] En figure 6B on reprend cet enchainement d'étapes. Il y a d'abord une étape de dépôt de matériau diélectrique E1, comme évoqué en relation avec la figure 5, puis une étape de gravure anisotrope du matériau diélectrique E2, comme aussi évoquée en lien avec la figure 5. Sur la figure 6B, les deux étapes sont dissociées pour faciliter la lecture.

Puis il y a une étape de dépôt du matériau conducteur E3, comme évoqué en lien avec la figure 6, et enfin une étape de gravure anisotrope du matériau conducteur E4, comme aussi évoqué en relation avec la figure 6. Sur la figure 6B, les deux étapes sont dissociées pour faciliter la lecture.

L'étape de gravure du diélectrique étant effectuée avant l'étape de dépôt du matériau conducteur, les espaceurs conducteurs 61 et 62 sont, à leurs extrémités inférieures, au contact du diélectrique de grille 31.

On va maintenant décrire un enchainement alternatif d'étapes.

[Fig. 6C] Dans une variante de mode de réalisation représentée en figure 6C, le cycle précédemment décrit est remplacé par un enchaînement d'étapes de dépôt diélectrique (E'1), puis dépôt matériau conducteur (E'2), gravure anisotrope du matériau conducteur (E'3), et enfin gravure anisotrope du matériau diélectrique (E'4).

Il y a donc finalement la présence de deux portions 51a et 52a de diélectrique supplémentaire sous les espaceurs en matériau conducteur, les séparant du diélectrique de grille 31.

Cette manière de faire permet de surmonter des imperfections de la sélectivité des gravures vis-à-vis du diélectrique de grille 31. La surépaisseur de diélectrique résultant de l'inversion des étapes de procédé compense alors une érosion progressive de ce dernier.

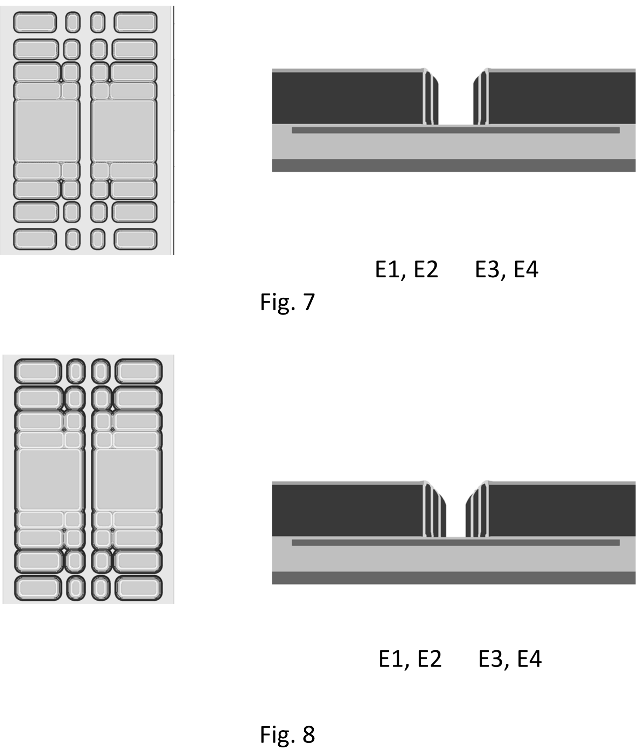

[Fig. 7] En figure 7, on a représenté le résultat d'une, selon le même principe (en reprenant la séquence de la figure 6B, mais il est aussi bien sûr, possible de poursuivre avec les principes de la figure 6C),
- étape de dépôt E1 (non représenté, mais assimilable à un dépôt conforme) puis gravure anisotrope E2 d'un 2^{eme} espaceur en matériau diélectrique avec à nouveau une épaisseur de 5 à 10 nm. Il recouvre la surface en matériau conducteur qui avait été mise en place à l'étape précédente. Encore une partie de la tranchée est occupée, sur un flanc, et une autre partie sur l'autre flanc. Si la tranchée est très étroite, elle est déjà pleine. Par contre les tranchées plus larges ne sont pas pleines à ce stade - elles le seront à une étape ultérieure
- suivie d'une étape de dépôt E3 (non représenté, mais assimilable à un dépôt conforme) puis gravure anisotrope E4 d'un 2^{e} conducteur (ou espaceur conducteur) avec encore une épaisseur de 5 à 15 nm. Ce deuxième espaceur conducteur est isolé électriquement du premier espaceur conducteur par le deuxième espaceur diélectrique. Si la tranchée est étroite, elle est déjà pleine. Par contre les tranchées plus larges ne sont pas pleines à ce stade - elles le seront à une étape ultérieure.

[Fig. 8] En figure 8, on a représenté le résultat d'une nouvelle double étape de mise en place d'espaceurs isolants et d'espaceurs conducteurs.

Les étapes successives sont effectuées avec les mêmes procédés.

Par construction, la hauteur des espaceurs risque d'être de plus en plus faible au fil des cycles (comme cela est représenté aux figures), du fait des limites des techniques utilisées, mais c'est un effet sans conséquence sur le caractère fonctionnel du système.

En termes de dimensionnement, l'empilement initial doit être haut (selon la direction verticalement ou perpendiculairement au substrat), au moins du même ordre de grandeur que l'espace dans lequel on souhaite définir les grilles, horizontalement dans le plan du substrat est large, pour la plus large des tranchées.

Le dernier matériau déposé est soit un espaceur diélectrique soit un conducteur en fonction de la largeur de la tranchée - le résultat dépend en fait de la largeur de la tranchée.

L'espace est rempli horizontalement plus tôt au cours des cycles successifs, après moins de cycles de dépôt d'isolant et de conducteur, s'il est étroit (typiquement dans la tranchée T4 en figure 4), et plus tard au cours des cycles successifs, après plus de cycles de dépôt d'isolant et de conducteur, s'il est large (typiquement dans la tranchée T2 ou la tranchée T7 en figure 4).

Les flancs extérieurs des îlots font l'objet de dépôt d'espaceurs, de manière similaire, sauf en ce qu'il n'y a pas, pour ces flancs, de flanc en vis-à-vis de l'autre côté d'une tranchée, en l'absence d'une telle tranchée. Les iles et îlots sont ainsi entourés, sur leurs circonférences respectives, de périmètres continus constitués chacun d'un espaceur, les périmètres successifs d'un îlot s'élargissant au cours des différentes étapes.

Les îlots les plus éloignés du nanofil sont entourés de plusieurs, par exemple trois, surfaces conductrices périmètriques, isolés chacun des autres éléments conducteurs du dispositif. Ces surfaces conductrices périmétriques résultent du procédé de fabrication présenté et sont chacune isolées sur leurs deux flancs (flanc intérieur et flanc extérieur) par des espaceurs isolants, sur l'ensemble de leur périmètre.

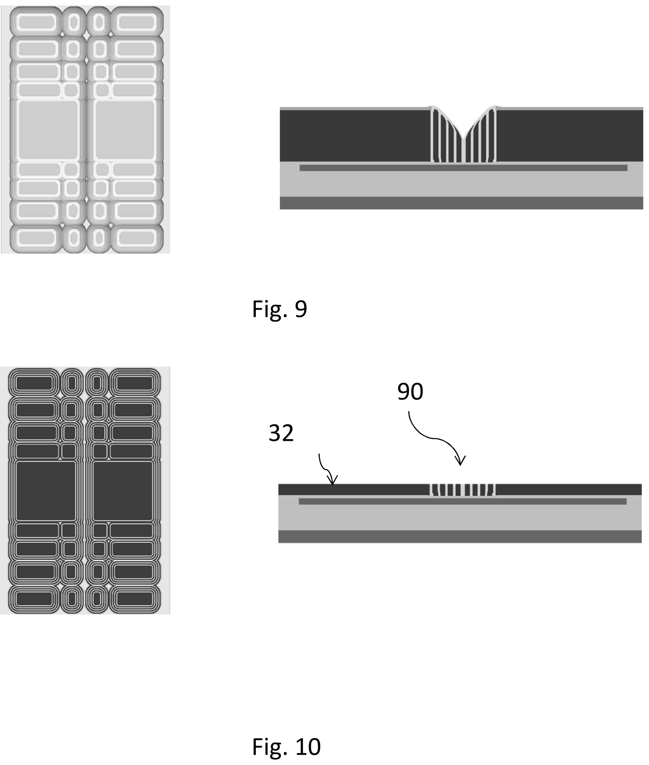

[Fig. 9] En figure 9, on a représenté la fin des dépôts, le dernier dépôt étant dans le cas représenté un dépôt diélectrique.

[Fig. 10] En figure 10, on a représenté le résultat d'un polissage mécano-chimique CMP optionnel, de nature à aplanir la surface supérieure de la structure, et notamment à faire disparaître la pente existante dans les tranchées comblées d'espaceurs. Le polissage est mené pour obtenir une surface plane, dont la majeure partie est en matériau conducteur électrique 32. Dans les tranchées, qui sont toutes entièrement comblées, affleurent des espaceurs formant une alternance 90 d'espaceurs conducteurs et isolants. Les espaceurs conducteurs ont une surface polie affleurante qui constitue une piste conductrice à la surface du dispositif électronique, ces pistes sont des lignes de grille, puisqu'elles ont essentiellement une forme linéique, et qu'elles assurent le rôle de grille vis-à-vis de la zone active, à savoir le nanofil, à leur extrémité qui lui fait face et le recouvre au moins partiellement pour moduler localement le potentiel électrostatique dans la zone active. Elles sont isolées électriquement les unes des autres du fait de l'alternance des espaceurs électriques et des espaceurs conducteurs.

D'un côté de la tranchée T2, les arrangements suivants sont en conséquence présents :

En partant du nanofil et en s'éloignant vers le petit côté du substrat :
- L'île, tout d'abord, est au-dessus du nanofil.
- Ensuite, les îlots les plus proches du nanofil sont entourés d'un périmètre conducteur qui est prolongé via un embranchement dans la matière conductrice, par un espaceur spécifique dans la tranchée T2, sur le bord de celui-ci, jusqu'au-dessus du nanofil.
- Les îlots suivants, après la première tranchée parallèle au nanofil, sont entourés d'un périmètre conducteur isolé des autres éléments conducteurs du dispositif. Ce périmètre isolé est unique. Il est entouré par un autre périmètre conducteur prolongé via un embranchement dans la matière conductrice, par un espaceur spécifique dans la tranchée T2, jusqu'au-dessus du nanofil.
- Les îlots suivants, après la deuxième tranchée parallèle au nanofil, sont entourés de deux périmètres conducteurs isolés chacun l'un de l'autre et des autres éléments conducteurs du dispositif, et de taille croissante. Ils sont entourés par un autre périmètre conducteur prolongé via un embranchement dans la matière conductrice, par un espaceur spécifique dans la tranchée T2, jusqu'au-dessus du nanofil.
- Les îlots les plus éloignés du nanofil, après la troisième tranchée parallèle au nanofil, sont entourés de trois périmètres conducteurs isolés chacun les uns des autres des autres éléments conducteurs du dispositif, et de taille croissante. Ils sont entourés par un autre périmètre conducteur prolongé via un embranchement dans la matière conductrice, par un espaceur spécifique dans la tranchée T2, jusqu'au-dessus du nanofil.

Les ilots ont une surface polie affleurante sur la face du dispositif électronique quantique. Cette surface est en matériau électriquement isolant, ou en matériau électriquement conducteur, en fonction du choix du matériau utilisé lors de l'étape de la figure 3.

On a à ce stade ainsi préparé et relié au nanofil, et en tenant compte des deux côtés de la tranchée T2
- 2x1 = 2 plots d'accès latéraux pour la source et le drain respectivement (les deux îles)
- 2x4 = 8 plots d'accès pour des grilles intermédiaires, pour définir 4 boîtes quantiques.

Il convient encore de les individualiser et les relier.

[Fig. 11] En figure 11, on a représenté une étape de lithographie et gravure pour
- remettre à nu la source S et le drain D à l'extrémité du nanofil (ou les deux sources S et les deux drains D à l'extrémité des deux nanofils si deux nanofils ont été préparés, ce qui est le cas sur la figure) de la zone active,
- décourt-circuiter les grilles en vis-à-vis dans le cas où deux nanofils sont définis (comme représenté sur la figure),
- et réaliser des ouvertures dans le matériau de grille.

En partie haute de la figure 11, vue de dessus, on a représenté la structure en cours de lithographie, et notamment on visualise le masque 1100. Il est prévu de former une tranchée de part en part entre les deux nanofils. Il est aussi prévu que les iles et les îlots soient coupés par gravure du côté des grands côtés du substrat de telle sorte que les périmètres conducteurs et isolants sont tous interrompus.

En partie basse de la figure, vue en coupe, on a représenté la structure à l'issue de l'étape de gravure. Dans les parties gravées, le nanofil 20, l'isolant 21 l'entourant ou l'isolant sous-jacent est mis à nu.

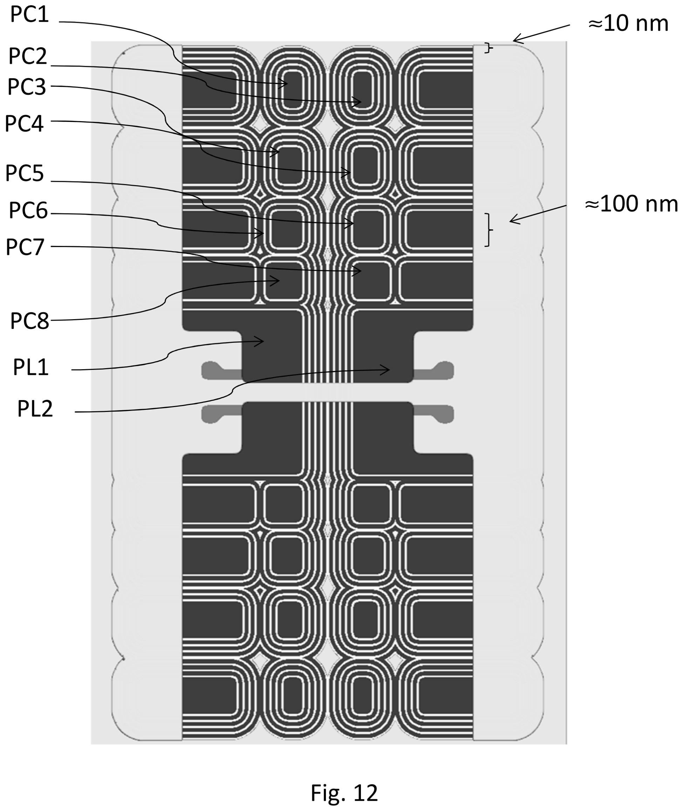

[Fig. 12] En figure 12, on a représenté le résultat de la gravure des grilles, vu du dessus. Le procédé a permis la mise en place, par nanofil, de
- 8 ilots de facilitation de reprise de contact centraux déportés PC1 à PC8 qui sont associés à la zone du nanofil par chacun un espaceur conducteur spécifique dont une partie latérale suit le flanc de l'ilot et s'étendant dans la tranchée centrale pour constituer une ligne de grille- les ilots de facilitation de reprise de contact sont entourés d'une alternance d'espaceurs diélectriques et d'espaceurs conducteurs en nombres qui vont croissants avec la distance vis-à-vis de la zone active et
- deux plots latéraux dits grilles d'accès ou access gates PL1 et PL2, qui subsistent sur la partie gauche et la partie droite du nanofil et qui sont d'ores et déjà reliés à la zone de nanofil.
Les plots latéraux sont assimilables à des îles et les plots de contact centraux sont assimilables à des îlots. Ils forment des surfaces isolées de dimension au moins supérieures à la largeur des pistes formées par les lignes de grille, et même plus de 5 fois plus larges. Un îlot a une dimension de l'ordre de 100 nm, là où une piste formée par une ligne de grille a une largeur de l'ordre de 5 à 10 nm. Les ilots sont des ilots de facilitation de reprise de contact pour les lignes de grille qui leur sont associées. Chaque ilot de facilitation de reprise de contact comprend un flanc le long duquel une partie latérale d'une ligne de grille s'étend.

Chaque espaceur conducteur est, au droit du nanofil, séparé du nanofil par et uniquement par la couche de diélectrique de grille.

Incidemment ces 10 plots de connexion formant grilles ont été construits pour chacun des deux nanofils, dans une géométrie en miroir en double, puisque le mode de réalisation représenté porte sur un système à deux nanofils, et qu'il y a, sur la figure 12, 2x10 = 20 grilles.

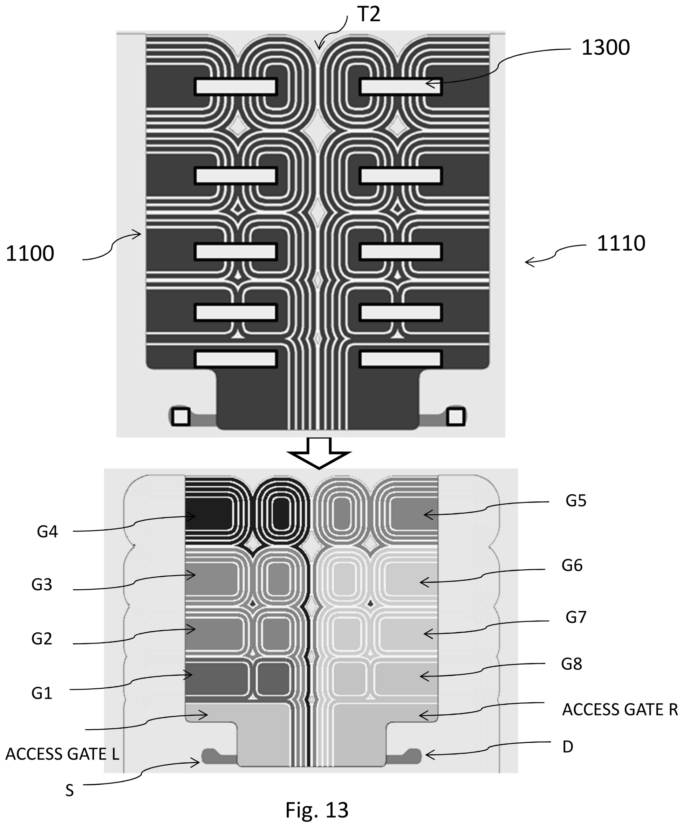

[Fig. 13] En figure 13, en partie haute, on a représenté la reprise de contact, qui s'effectue sur les branchages latéraux de gauche 1100, pour quatre contacts, et sur les branchages latéraux de droite 1110 pour quatre autre contacts. On dispose des contacts électriques pour contacter les lignes de grille, ligne par ligne, les contacts électriques étant situés sur la partie latérale de la ligne de grille donnée qui s'étend le long du flanc d'un ilot de facilitation de reprise de contact. Cela permet de bénéficier d'une tolérance pour le positionnement du contact. Dans la conception de la figure 13, un contact électrique joint une partie latérale d'une des lignes de grille entre deux ilots et ces deux ilots sont disposés l'un par rapport à l'autre dans une direction parallèle à une direction d'allongement du nanofil formant la zone active.

Des contacts 1300 sous la forme chacun d'un cylindre, d'un pavé ou d'une piste, d'emprise, vue du dessus, essentiellement rectangulaire (comme représenté) ou oblongue (en variante non représentée) sont utilisés pour assurer la polarisation commune de groupes, par contact, de lignes - la partie affleurante des espaceurs conducteurs - adjacentes, en établissant un contact au-dessus de l'espaceur isolant intercalé, ou des espaces isolants intercalés. Cette démarche permet de mettre à isopotentiel les îlots et le périmètre conducteur associé qui est prolongé jusqu'au-dessus du nanofil dans la tranchée T2.

Les contacts ont une largeur suffisante pour faciliter la reprise de contact sans contrainte importante en matière d'alignement. Ils sont dispersés sur une surface bien plus importante que celle du nanofil.

Les régions d'iso-potentiel résultantes sont identifiées sur la partie basse de la figure (les potentiels sont transmis aux ilots uniquement si la surface de ceux-ci est conductrice, naturellement).

Ce design avec 8 grilles latérales et deux grilles d'accès permet de mettre en place 4 boites quantiques. Une grille sur deux est dédiée au contrôle du potentiel des boîtes quantiques. Et l'autre sert au contrôle de la barrière à effet tunnel entre deux boîtes adjacentes.

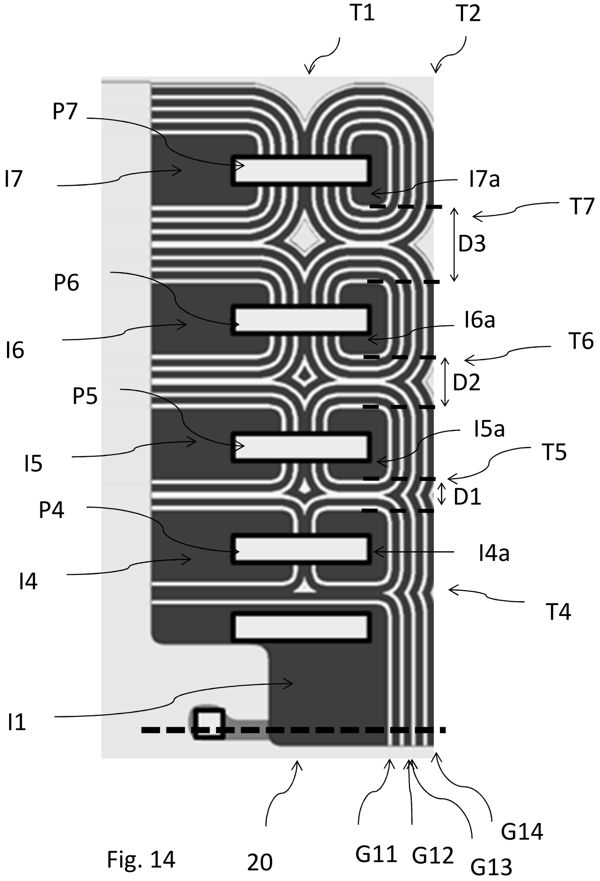

[Fig. 14] En figure 14, on a représenté la moitié gauche de la structure de la figure 13, pour ne pas surcharger l'image. Les îlots I4 et I4a séparent les tranchées T4 et T5, les îlots I5 et I5a séparent les tranchées T5 et T6, les îlots I6 et I6a séparent les tranchées T6 et T7 et les îlots I7 et I7a s'étendent après la tranchée T7.

La distance D1, D2, D3 entre deux ilots successifs est représentée sur la figure. Cette distance entre deux ilots successifs est croissante au fur et à mesure de l'éloignement des ilots par rapport à la zone active. Plus un ilot est éloigné de la zone active, plus l'ilot est éloigné de l'ilot le précédant et également de l'ilot le suivant.

La tranchée T1 sépare l'îlot I4 de l'îlot I4a, l'îlot I5 de l'îlot I5a, l'îlot I6 de l'îlot I6a et l'îlot I7 de l'îlot I7a.

La section de la tranchée T1 entre les îlots I4 et I4a est étroite et contient donc un seul espaceur conducteur, pour la grille la plus à gauche sur le nanofil sur la figure, référencée G11. Cet espaceur conducteur unique est formé de la jointure d'une paire d'espaceurs puisqu'on a à la fois la partie circonférentielle d'un espaceur faisant le tour de l'ilot I4 et la partie circonférentielle d'un espaceur faisant le tour de l'ilot I4a en contact au centre de la tranchée, cette dernière contactant électriquement l'espaceur définissant la grille G11.

La section de la tranchée T1 entre les îlots I5 et I5a est plus large, et contient trois espaceurs conducteurs (deux espaceurs d'une paire en miroir, et un espaceur central formé de la jointure d'une paire d'espaceurs), dans l'ordre :
- un espaceur conducteur isolé - c'est un espaceur conducteur circonférentiel autour de l'îlot I5.
- un espaceur conducteur pour la grille suivante sur le nanofil, à savoir la deuxième en partant de la gauche sur le nanofil, référencée G12
- et un autre espaceur conducteur, isolé - c'est un espaceur conducteur circonférentiel autour de l'îlot I5a.

La section de la tranchée T1 entre les îlots I6 et I6a est encore plus large, et contient cinq espaceurs conducteurs (quatre espaceurs de deux paires en miroir, et un espaceur central formé de la jointure d'une paire d'espaceurs), dans l'ordre:
- deux espaceurs conducteurs circonférentiels isolés autour de l'îlot I6
- un espaceur conducteur pour la troisième grille en partant de la gauche sur le nanofil sur la figure, G13
- deux espaceurs conducteurs circonférentiels isolés autour de l'îlot I6a.

La section de la tranchée T1 entre les îlots I7 et I7a est encore plus large, et contient sept espaceurs conducteurs (six espaceurs de trois paires en miroir, et un espaceur central formé de la jointure d'une paire d'espaceurs), dans l'ordre:
- trois espaceurs conducteurs circonférentiels isolés autour de l'îlot I7
- un espaceur conducteur pour la quatrième grille en partant de la gauche sur le nanofil sur la figure, G14
- trois espaceurs conducteurs circonférentiels isolés autour de l'îlot I7a.

Au niveau de la tranchée T1, il est facile de former un contact connectant une unique grille, de nombreuses portions étant électriquement isolées des autres grilles du dispositif.

Ainsi, le plot P4 de reprise de contact pour la grille G11 peut être positionné au-dessus de la tranchée T1 en tirant profit des surfaces isolées adjacentes constituées par les îlots I4 et I4a. P4, tant qu'il contacte l'espaceur de G11 peut être positionné librement du côté de l'îlot I4 ou de l'îlot I4a sans que cela ne provoque de court-circuit.

Le plot P5 de reprise de contact pour la grille G12 peut être positionné au-dessus de la tranchée T1 en tirant profit des surfaces isolées adjacentes constituées par les îlots I5 et I5a. P5, tant qu'il contacte l'espaceur de G12 peut être positionné librement du côté de l'îlot I5 ou de l'îlot I5a sans que cela ne provoque de court-circuit.

Le plot P6 de reprise de contact pour la grille G13 peut être positionné au-dessus de la tranchée T1 en tirant profit des surfaces isolées adjacentes constituées par les îlots I6 et I6a. P6, tant qu'il contacte l'espaceur de G13 peut être positionné librement du côté de l'îlot I6 ou de l'îlot I6a sans que cela ne provoque de court-circuit.

Enfin, le plot P7 de reprise de contact pour la grille G14 peut être positionné au-dessus de la tranchée T1 en tirant profit des surfaces isolées adjacentes constituées par les îlots I7 et I7a. P7, tant qu'il contacte l'espaceur de G14, peut être positionné librement du côté de l'îlot I7 ou de l'îlot I7a sans que cela ne provoque de court-circuit.

Ainsi, un contact peut être placé à cheval sur une partie latérale d'une des lignes de grille, deux îlots de facilitation de reprise de contact voisins et au moins deux espaceurs diélectriques. C'est le cas de chacun des plots P4 à P7.

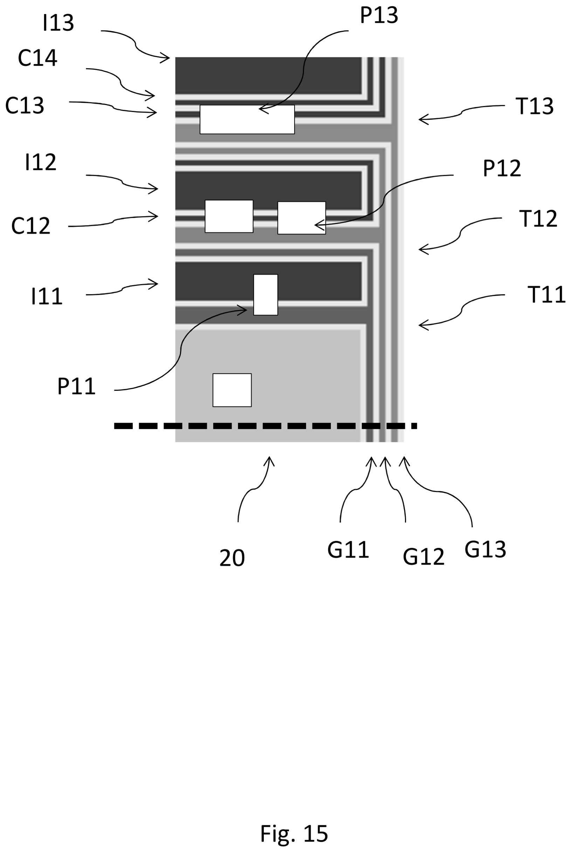

[Fig. 15] En figure 15 on a représenté une variante de conception, n'utilisant pas un réseau en deux dimensions de tranchées, mais seulement une succession de tranchées (ici au nombre de trois) parallèles au nanofil 20, de tailles croissantes quand on s'éloigne du nanofil, et qui facilite la reprise de contact. Les tranchées sont séparées par des îlots. Dans cette conception, un contact électrique joint une partie latérale d'une des lignes de grille entre deux ilots, et ces deux ilots sont disposés l'un par rapport à l'autre dans une direction transversale, en l'occurrence perpendiculaire, au nanofil et donc à une direction d'allongement de la zone active. Il y a un ilot de facilitation de reprise de contact par ligne de grille.

L'îlot I11 sépare les tranchées T11 et T12, l'îlot I12 sépare les tranchées T12 et T13 et l'îlot I13 s'étend après la tranchée T13. A nouveau les ilots sont des ilots de facilitation de reprise de contact et comprennent un flanc le long duquel une partie latérale d'une ligne de grille s'étend, en l'occurrence sous la forme d'un espaceur conducteur dans une tranchée. La distance entre deux ilots de facilitation de reprise de contact voisins augmente avec la distance vis-à-vis de la zone active.

Ici, la tranchée T11 est étroite et contient donc un seul espaceur conducteur, pour la grille la plus à gauche sur le nanofil sur la figure, référencée G11.

La tranchée T11 est suivie, en s'éloignant du nanofil 20 de la tranchée T12, qui est plus large, et qui contient trois espaceurs conducteurs,
- un espaceur conducteur pour la grille la plus à gauche sur le nanofil sur la figure, G11
- un deuxième espaceur conducteur pour la grille suivante sur le nanofil, à savoir la deuxième en partant de la gauche sur le nanofil, référencée G12
- et un troisième espaceur conducteur, qui est lui isolé - c'est un espaceur conducteur circonférentiel autour de l'îlot I12, référencé C12.

La tranchée T12 est suivie, toujours en s'éloignant du nanofil 20, de la tranchée T13, qui est encore plus large, et qui contient cinq espaceurs conducteurs,
- l'un isolé, c'est l'espaceur conducteur circonférentiel autour de l'îlot I12, mentionné ci-dessus, C12
- le deuxième pour la deuxième grille en partant de la gauche sur le nanofil sur la figure, G12 un troisième pour la grille suivante sur le nanofil, à savoir la troisième grille en partant de la gauche sur le nanofil, référencé G13
- un quatrième isolé et un cinquième isolé, ce sont tous les deux des espaceurs conducteurs circonférentiels autour de l'îlot I13, référencés C13 et C14.

Au niveau des tranchées, il est facile de former un contact connectant une unique grille, de nombreuses portions étant électriquement isolées des autres grilles du dispositif.

Ainsi, le plot P11 de reprise de contact pour la grille G11 peut être positionné au-dessus de la tranchée T11 en tirant profit de la surface isolée adjacente constituée par l'îlot I11. P11, tant qu'il contacte l'espaceur de G11 peut être positionné librement du côté de l'îlot I11 sans que cela ne provoque de court-circuit. Ainsi un contact électrique peut être placé à cheval sur un ilot de facilitation de reprise de contact, un espaceur diélectrique et une partie latérale d'une des lignes de grille. C'est le cas du plot P11 et aussi du plot P12.

Le plot P12 de reprise de contact pour la grille G12 peut être positionné au-dessus de la tranchée T12 en tirant profit de la surface isolée adjacente constituée par l'îlot I12. P12, tant qu'il contacte l'espaceur de G12 peut être positionné librement du côté de l'îlot I12 sans que cela ne provoque de court-circuit.

Enfin, le plot P13 de reprise de contact pour la grille G13 peut être positionné au-dessus de la tranchée T13 en tirant profit de la surface isolée adjacente constituée par l'îlot I13. P13, tant qu'il contacte l'espaceur de G13, peut être positionné librement du côté de l'îlot I13 sans que cela ne provoque de court-circuit.

Cette variante n'impose pas de contrainte sur la dimension des contacts.

Pour minimiser la résistance des reprises de contact, il est possible d'en placer plusieurs au-dessus d'une même tranchée ou de les allonger selon la direction de la tranchée.

On constate comme en figure 14 que plus un ilot est éloigné de la zone active, plus l'ilot est éloigné de l'ilot le précédant et également de l'ilot le suivant.

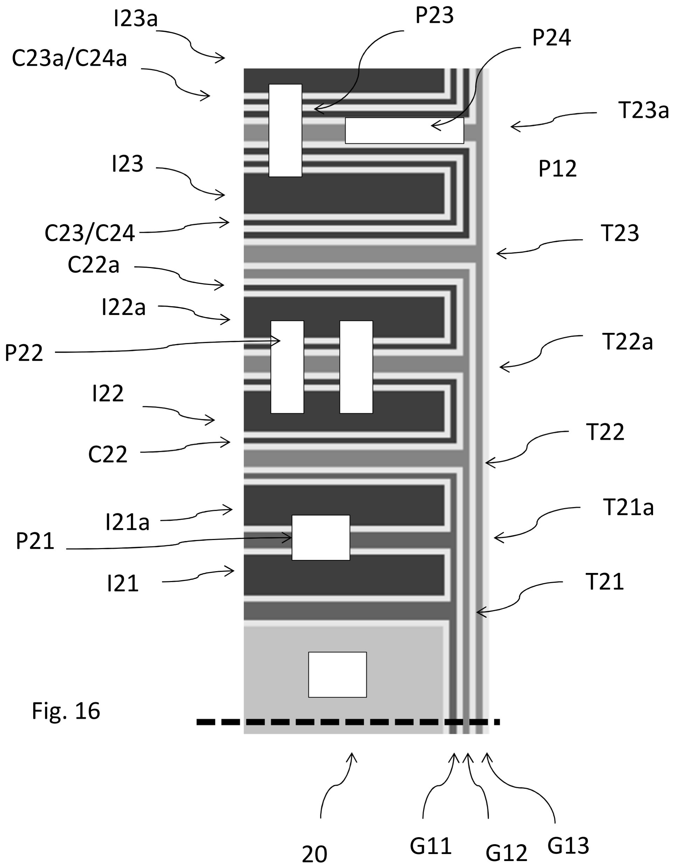

[Fig. 16] En figure 16, on a représenté une autre variante, avec une succession de tranchées de largeur généralement croissante quand on s'éloigne du nanofil 20, mais dans la succession, une largeur supérieure de tranchée n'étant adoptée qu'après que deux tranchées successives ait eu la même largeur.

Ainsi, on voit une succession de tranchées (ici au nombre de cinq) parallèles au nanofil 20. Les tranchées sont séparées par des îlots. A nouveau les ilots sont des ilots de facilitation de reprise de contact et comprennent un flanc le long duquel une partie latérale d'une ligne de grille s'étend, en l'occurrence sous la forme d'un espaceur conducteur dans une tranchée. Il y a deux ilots de facilitation de reprise de contact par ligne de grille.

L'îlot I21 sépare les tranchées T21 et T21a, l'îlot I21a sépare les tranchées T21a et T22, l'îlot I22 sépare les tranchées T22 et T22a, l'îlot I22a sépare les tranchées T22a et T23, l'îlot I23 sépare les tranchées T23 et T23a, et l'îlot I23a s'étend après la tranchée T23a.

Ici, les tranchées T21 et T21a sont de même largeur et étroites et contiennent donc un seul espaceur conducteur, pour la grille la plus à gauche sur le nanofil sur la figure, référencée G11.

La tranchée T21a est suivie, en s'éloignant du nanofil 20 de la tranchée T22 et de la tranchée T22a, qui sont de même largeur et plus larges que les précédentes, et qui contiennent chacune trois espaceurs conducteurs,

### Pour T22

- un espaceur conducteur pour la grille la plus à gauche sur le nanofil sur la figure, G11
- un deuxième espaceur conducteur pour la grille suivante sur le nanofil, à savoir la deuxième en partant de la gauche sur le nanofil, référencée G12
- et un troisième espaceur conducteur, qui est lui isolé - c'est un espaceur conducteur circonférentiel autour de l'îlot I22, référencé C22.

### Pour T22a

- l'espaceur conducteur, isolé -circonférentiel autour de l'îlot I22, référencé C22
- à nouveau le deuxième espaceur conducteur pour la grille suivante sur le nanofil, à savoir la deuxième en partant de la gauche sur le nanofil, référencée G12
- et un troisième espaceur conducteur, qui est lui isolé - c'est un espaceur conducteur circonférentiel autour de l'îlot I22a, référencé C22a.

La tranchée T22a est suivie, toujours en s'éloignant du nanofil 20, des tranchées T23 et T23a, qui sont de même largeur et encore plus larges que les précédentes, et qui contiennent chacune cinq espaceurs conducteurs,

### Pour T23

- l'un isolé, c'est l'espaceur conducteur circonférentiel autour de l'îlot I22a, mentionné ci-dessus, C22a
- le deuxième pour la deuxième grille en partant de la gauche sur le nanofil sur la figure, G12
- un troisième pour la grille suivante sur le nanofil, à savoir la troisième grille en partant de la gauche sur le nanofil, référence G13
- un quatrième isolé et un cinquième isolé, ce sont tous les deux des espaceurs conducteurs circonférentiels autour de l'îlot I23, référencés C23 et C24.

### Pour T23a

- les deux espaceurs C23 et C24, isolés tous les deux
- un troisième espaceur pour la grille suivante sur le nanofil, à savoir la troisième grille en partant de la gauche sur le nanofil, référence G13
- un quatrième isolé et un cinquième isolé, ce sont tous les deux des espaceurs conducteurs circonférentiels autour de l'îlot I23a, référencés C23a et C24a.

Au niveau des tranchées, il est facile de former un contact connectant une unique grille, de nombreuses portions étant électriquement isolées des autres grilles du dispositif.

Ainsi, le plot P21 de reprise de contact pour la grille G11 peut être positionné au-dessus de la tranchée T21a en tirant profit des deux surfaces isolées adjacentes constituées par les îlots I21 et I21a. P11, tant qu'il contacte l'espaceur de G11 peut être positionné librement du côté de l'îlot I21 ou de l'îlot I21a sans que cela ne provoque de court-circuit.

Le plot P22 de reprise de contact pour la grille G12 peut être positionné au-dessus de la tranchée T22a en tirant profit des surfaces isolées adjacentes constituées par les îlots I22 et I22a. P22, tant qu'il contacte l'espaceur de G12 peut être positionné librement du côté de l'îlot I22 ou du côté de l'îlot I22a sans que cela ne provoque de court-circuit.

Enfin, le plot P23 de reprise de contact pour la grille G13 peut être positionné au-dessus de la tranchée T23a en tirant profit des surfaces isolées adjacentes constituées par les îlots I23 et I23a. P23, tant qu'il contacte l'espaceur de G13, peut être positionné librement du côté de l'îlot I23 ou de l'îlot I23a sans que cela ne provoque de court-circuit.

Ainsi, un contact est placé à cheval sur une partie latérale d'une des lignes de grille et un espaceur diélectrique sans avoir de contact avec un ilot de facilitation de reprise de contact. C'est le cas du plot P24.

Ou un contact peut être placé à cheval sur une partie latérale d'une des lignes de grille, deux îlots de facilitation de reprise de contact voisins et au moins deux espaceurs diélectriques. C'est le cas des plots P21, P22 et P23.

On peut dans cette variante reprendre des contacts sans difficulté. Ces derniers peuvent être allongés selon la direction des tranchées pour minimiser la résistance des reprises de contact et/ou selon la direction transverse pour minimiser les contraintes d'alignement.

On constate comme en figure 14 et en figure 15 que plus un ilot est éloigné de la zone active, plus l'ilot est éloigné de l'ilot le précédant et également de l'ilot le suivant.

## Revendications

1. Dispositif électronique quantique comprenant :
- une zone active (20) pour accueillir des boites quantiques et,
- affleurants sur une face du dispositif :
a) une pluralité de lignes de grille (G11, G12, G13, G14), isolées électriquement les unes des autres et recouvrant chacune une partie de la zone active (20), et
b) des ilots de facilitation de reprise de contact (I4-I7, I4a-I7a; I11-I13 ; I21-I23a) à raison d'au moins un ilot pour une ligne de grille, les ilots de facilitation de reprise de contact étant éloignés les uns des autres d'une distance (D1, D2, D3), chaque ilot de facilitation de reprise de contact comprenant un flanc le long duquel une partie latérale (P4-P7; P11-P13 ; P21-P23) d'une ligne de grille s'étend,
le dispositif comprenant de plus
au moins un contact électrique (P4-P7 ; P11-P13 ; P21-P23) pour contacter au moins une ligne de grille donnée (G11, G12, G13, G14), l'au moins un contact électrique étant situé au moins sur la partie latérale de la ligne de grille donnée qui s'étend le long du flanc d'un ilot de facilitation de reprise de contact (I4-I7, I4a-I7a ; I11-I13 ; I21-I23a).

2. Dispositif électronique quantique selon la revendication 1, **caractérisé en ce que** les ilots de facilitation de reprise de contact (I4-I7, I4a-I7a; I11-I13; I21-I23a) sont entourés d'une alternance d'espaceurs diélectriques et d'espaceurs conducteurs en nombres qui vont croissants avec la distance vis-à-vis de la zone active (20).

3. Dispositif électronique quantique selon la revendication 1 ou la revendication 2, **caractérisé en ce que** la distance (D1, D2, D3) entre deux ilots de facilitation de reprise de contact voisins augmente avec la distance vis-à-vis de la zone active (20).

4. Dispositif électronique quantique selon l'une des revendications 1 à 3, **caractérisé en ce que** le dispositif comprend un substrat (10) en silicium massif ou en silicium sur isolant.

5. Dispositif électronique quantique selon l'une des revendications 1 à 4, **caractérisé en ce que** la zone active comprend un nanofil, notamment en silicium.

6. Dispositif électronique quantique selon l'une des revendications 1 à 5, **caractérisé en ce que** la zone active présente deux extrémités, au moins une des extrémités formant un réservoir de porteurs de charges.

7. Dispositif électronique quantique selon l'une des revendications 1 à 6, **caractérisé en ce que** les ilots de facilitation de reprise de contact ont une surface en matériau électriquement isolant, ou en matériau électriquement conducteur.

8. Dispositif électronique quantique selon l'une des revendications 1 à 7, **caractérisé en ce que** les lignes de grille forment des grilles d'ajustement local du potentiel électrostatique dans la zone active.

9. Dispositif électronique quantique selon l'une des revendications 1 à 8, **caractérisé en ce qu'**un contact électrique est placé à cheval sur un ilot de facilitation de reprise de contact, au moins un espaceur diélectrique et une partie latérale d'une des lignes de grille, ou à cheval sur une partie latérale d'une des lignes de grille et un espaceur diélectrique sans avoir de contact avec un ilot de facilitation de reprise de contact, ou à cheval sur une partie latérale d'une des lignes de grille, deux îlots de facilitation de reprise de contact voisins et au moins deux espaceurs diélectriques.

10. Dispositif électronique quantique selon l'une des revendications 1 à 9, **caractérisé en ce qu'**un contact électrique joint une partie latérale d'une des lignes de grille entre deux ilots disposés l'un par rapport à l'autre dans une direction essentiellement parallèle à une direction d'allongement de la zone active.

11. Dispositif électronique quantique selon l'une des revendications 1 à 9, **caractérisé en ce qu'**un contact électrique joint une partie latérale d'une des lignes de grille entre deux ilots disposés l'un par rapport à l'autre dans une direction transversale à une direction d'allongement de la zone active.

12. Procédé de fabrication d'un dispositif électronique quantique comprenant une mise en place, sur un substrat (10), d'une zone active (20), et d'une pluralité de lignes de grilles (G11, G12, G13, G14), isolées électriquement les unes des autres, et entre les lignes de grille et la zone active (20), d'une couche de matériau diélectrique (31), le procédé comprenant des étapes de formation de tranchées (T4-T7) par gravure dans un matériau conducteur posé sur le substrat, puis dépôts conformes successifs d'espaceurs diélectriques (E1 ; E'1) et d'espaceurs conducteurs (E3 ; E'2), des largeurs de tranchées allant croissantes en s'éloignant de la zone active (20), les espaceurs conducteurs formant la pluralité des lignes de grille, le procédé comprenant de plus la mise en place d'au moins un contact électrique pour contacter au moins une ligne de grille donnée, l'au moins un contact électrique étant situé au moins sur une partie latérale de la ligne de grille donnée s'étendant le long d'un flanc d'un ilot de facilitation de reprise de contact.

13. Procédé de fabrication d'un dispositif électronique quantique selon la revendication 12, **caractérisé en ce que** chaque dépôt conforme (E1, E3) est suivi d'une gravure anisotrope (E2, E4) avant le dépôt suivant ou les dépôts d'espaceurs diélectriques (E'1) et d'espaceurs conducteurs (E'2) sont effectués avant des gravures anisotropes du matériau conducteur (E'3) puis du matériau diélectrique (E'4).

14. Procédé de fabrication d'un dispositif électronique quantique selon la revendication 12 ou la revendication 13, **caractérisé en ce que** les tranchées comprennent des tranchées en maillage, une tranchée transversale (T1, T3) au conducteur allongé (20) s'élargissant en s'éloignant du conducteur allongé (20) à chaque croisement d'une tranchée parallèle (T4-T7) au conducteur allongé (20).
